# EUROPEAN PATENT APPLICATION

(11) **EP 2 048 668 A1**
(43) Date of publication of application: **15.04.2009**
(21) Application number: 08014811.7
(22) Date of filing: 21.08.2008
(51) Int. Cl.: G11C 16/02

(54) **Integrated circuit including a memory having a data inversion circuit**

(30) Priority: 08.10.2007 US 868729
(71) Applicant: Qimonda AG, 81739 München (DE)
(72) Inventor: Dietrich, Stefan, 82299 Türkenfeld (DE); Schrögmeier, Peter, 81547 München (DE)

(57) **Abstract**

An integrated circuit includes an array of resistivity changing memory cells. The integrated circuit includes a circuit configured to invert a data word to be written to the array in response to determining that writing the inverted data word would use less power than writing the non-inverted data word.

## Description

### Background

One type of memory is resistive memory. Resistive memory utilizes the resistance value of a memory element to store one or more bits of data. For example, a memory element programmed to have a high resistance value may represent a logic "1" data bit value and a memory element programmed to have a low resistance value may represent a logic "0" data bit value. Typically, the resistance value of the memory element is switched electrically by applying a voltage pulse or a current pulse to the memory element.

One type of resistive memory is phase change memory. Phase change memory uses a phase change material in the resistive memory element. The phase change material exhibits at least two different states. The states of the phase change material may be referred to as the amorphous state and the crystalline state, where the amorphous state involves a more disordered atomic structure and the crystalline state involves a more ordered lattice. The amorphous state usually exhibits higher resistivity than the crystalline state. Also, some phase change materials exhibit multiple crystalline states, e.g. a face-centered cubic (FCC) state and a hexagonal closest packing (HCP) state, which have different resistivities and may be used to store bits of data. In the following description, the amorphous state generally refers to the state having the higher resistivity and the crystalline state generally refers to the state having the lower resistivity.

Phase changes in the phase change materials may be induced reversibly. In this way, the memory may change from the amorphous state to the crystalline state and from the crystalline state to the amorphous state in response to temperature changes. The temperature changes of the phase change material may be achieved by driving current through the phase change material itself or by driving current through a resistive heater adjacent the phase change material. With both of these methods, controllable heating of the phase change material causes controllable phase change within the phase change material.

A phase change memory including a memory array having a plurality of memory cells that are made of phase change material may be programmed to store data utilizing the memory states of the phase change material. One way to read and write data in such a phase change memory device is to control a current and/or a voltage pulse that is applied to the phase change material. The temperature in the phase change material in each memory cell generally corresponds to the applied level of current and/or voltage to achieve the heating. The amount of current used to program a phase change memory should be minimized to conserve power.

For these and other reasons, there is a need for the present invention.

### Summary

One embodiment provides an integrated circuit. The integrated circuit includes an array of resistivity changing memory cells. The Integrated circuit Includes a circuit configured to invert a data word to be written to the array in response to determining that writing the inverted data word would use less power than writing the non-inverted data word.

### Brief Description of the Drawings

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description. The elements of the drawings are not necessarily to scale relative to each other. Like reference numerals designate corresponding similar parts.
Figure 1 is a block diagram illustrating one embodiment of a system.
Figure 2 is a diagram illustrating one embodiment of a memory device.
Figure 3 is a flow diagram illustrating one embodiment of a method for writing to a memory array.
Figure 4 is a flow diagram illustrating another embodiment of a method for writing to a memory array.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

If is to be understood that the features of the various exemplary embodiments described herein may be combined with each other, unless specifically noted otherwise.

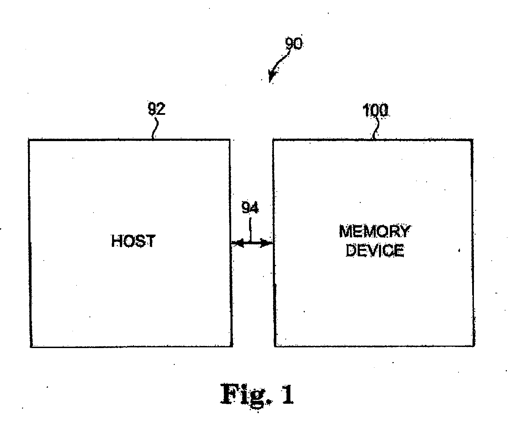

Figure 1 is a block diagram illustrating one embodiment of a system 90. System 90 includes a host 92 and a memory device 100. Host 92 is communicatively coupled to memory device 100 through communication link 94. Host 92 includes a computer (e.g., desktop, laptop, handheld), portable electronic device (e.g., cellular phone, personal digital assistant (PDA), MP3 player, video player), or any other suitable device that uses memory. Memory device 100 provides memory for host 92. In one embodiment, memory device 100 includes a phase change memory device or other suitable resistive or resistivity changing material memory device.

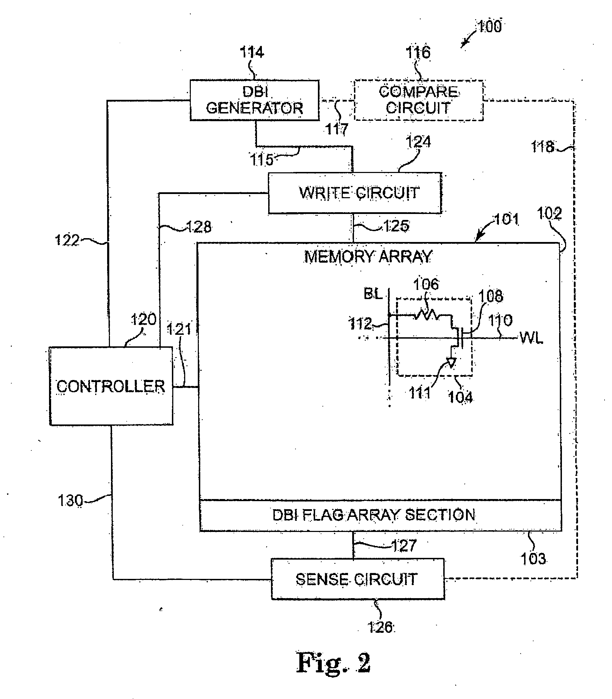

Figure 2 is a diagram illustrating one embodiment of memory device 100. In one embodiment, memory device 100 is an integrated circuit or part of an integrated circuit. Memory device 100 includes a data bit inversion (DBI) generator 114, an optional compare circuit 116, a write circuit 124, a controller 120, a memory array 101, and a sense circuit 126. Memory array 101 includes a section 102 for storing data and a section 103 for storing DBI flags. Memory array 101 includes a plurality of phase change memory cells, such as phase change memory cell 104, a plurality of bit lines, such as bit line (BL) 112, and a plurality of word lines, such as word line (WL) 110.

Memory device 100 is configured to use less power and/or to be more stable than a typical phase change memory device. More power is used to reset a phase change memory cell to an amorphous state than to set a phase change memory cell to a crystalline state. In addition, the crystalline state is more stable than the amorphous state. Therefore in one embodiment, to reduce the number of phase change memory cells that are reset to an amorphous state, memory device 100 inverts data words to be written to memory array 101 that include more data bits to be reset to the amorphous state than data bits to be set to the crystalline state. The inverted data word is then written to memory array 101 instead of the original non-inverted data word. A DBI flag is set and written to memory array 101 to indicate whether the data word is inverted, In this way, the number of memory cells that are reset to the amorphous state is minimized.

In another embodiment during write operations for a resistive memory other than a phase change memory, the number of resistive memory cells that are set is reduced. In this embodiment, memory device 100 inverts data words to be written to memory array 101 that include more data bits to be set than data bits to be reset. The inverted data word is then written to memory array 101 instead of the original non-inverted data word. The DBI flag is set and written to memory array 101 to indicate whether the data word is inverted.

In another embodiment, the total number of data bits to be written to memory array 101 is reduced using read-modify-write operations. In this embodiment, memory device 100 reads the data word in memory array 101 that is going to be overwritten. Memory device 100 then compares the read data word to the data word to be written. The data word to be written is then masked such that only the data bits that do not match the corresponding data bits within the read data word are overwritten in memory array 101. In this way, the number of memory cells that are overwritten is minimized.

In another embodiment, the total number of data bits to be written to memory array 101 is reduced using another embodiment of read-modify-write operations. In this embodiment, memory device 100 reads the data word in memory array 101 that is going to be overwritten. Memory device 100 then compares the read data word to the data word to be written. If the data word to be written includes fewer data bits that match the corresponding data bits within the read data word than data bits that do not match the corresponding data bits within the read data word, then the data word to be written is inverted. The inverted data word is then masked such that only the inverted data bits that do not match the corresponding data bits within the read data word are overwritten in memory array 101.

If the data word to be written includes more data bits that match the corresponding data bits within the read data word than data bits that do not match the corresponding data bits within the read data word, then the data word to be written is not inverted. The original non-inverted data word is then masked such that only the data bits that do not match the corresponding data bits within the read data word are overwritten in memory array 101. A DBI flag is set and written to memory array 101 to indicate whether the data word is inverted. In this way, the number of memory cells that are overwritten is minimized.

As used herein, the term "electrically coupled" is not meant to mean that the elements must be directly coupled together and intervening elements may be provided between the "electrically coupled" elements.

DBI generator 114 is electrically coupled to optional compare circuit 116 through signal path 117, to write circuit 124 through signal path 115, and to controller 120 through signal path 122. Write circuit 124 is electrically coupled to controller 120 through signal path 128 and to memory array 101 through signal path 125. Optional compare circuit 116 is electrically coupled to sense circuit 126 through signal path 118. Sense circuit 126 is electrically coupled to memory array 101 through signal path 127 and to controller 120 through signal path 130. Controller 120 is electrically coupled to memory array 101 through signal path 121.

Each phase change memory cell 104 is electrically coupled to a word line 110, a bit line 112, and a common or ground 111. Each phase change memory cell 104 includes a phase change element 106 and a transistor 108. While transistor 108 is a field-effect transistor (FET) in the illustrated embodiment, in other embodiments, transistor 108 can be another suitable device such as a bipolar transistor or a 3D transistor structure. In other embodiments, a diode-like structure may be used in place of transistor 108. If a diode-like structure is used, the diode-like structure and phase change element 106 are arranged in series between bit line 112 and word line 110.

One side of phase change element 106 is electrically coupled to bit line 112, and the other side of phase change element 106 is electrically coupled to one side of the source-drain path of transistor 108. The other side of the source-drain path of transistor 108 is electrically coupled to common or ground 111. The gate of transistor 108 is electrically coupled to word line 110. In another embodiment, one side of phase change element 106 is electrically coupled to common or ground 111. The other side of phase change element 106 is electrically coupled to one side of the source-drain path of transistor 108, and the other side of the source-drain path of transistor 108 is electrically coupled to bit line 112.

Each phase change element 106 comprises a phase change material that may be made up of a variety of materials in accordance with the present invention. Generally, chalcogenide alloys that contain one or more elements from group VI of the periodic table are useful as such materials. In one embodiment, the phase change material of phase change element 106 is made up of a chalcogenide compound material, such as GeSbTe, SbTe, GeTe or AglnSbTe. In another embodiment, the phase change material is chalcogen free, such as GeSb, GaSb. InSb, or GeGalnSb. In other embodiments, the phase change material is made up of any suitable material including one or more of the elements Ge, Sb, Te, Ga, As, In, Se, and S.

Each phase change element 106 may be changed from an amorphous state to a crystalline state or from a crystalline state to an amorphous state under the influence of temperature change. In the amorphous state, a phase change material exhibits significantly higher resistivity than in the crystalline state. Therefore, the two states of phase change elements 106 differ in their electrical resistivity. In one embodiment, the two states are assigned bit values of "0" and "1", where "0" represents the crystalline state and "1" represents the amorphous state.

Array section 102 of memory array 101 stores data or inverted data. DBI flag array section 103 stores DBI flags indicating whether associated data stored in array section 102 is inverted. In one embodiment, DBI flag array section 103 is part of an unused error correction code (ECC) array section. For example in one embodiment, data words of 32 bits use seven parity bits. Due to fabrication processes, however, eight bits are fabricated for each data word to store the parity information. Therefore, one extra bit location within the ECC array section for each data word is not used for ECC. This extra bit location can be used to store the DBI flag for the associated data word.

Controller 120 includes a microprocessor, microcontroller, or other suitable logic circuitry for controlling the operation of memory device 100. Controller 120 communicates with host 92 to receive data from host 92 to be stored in memory device 100 and to send data stored in memory device 100 to host 92. Controller 120 controls read and write operations of memory device 100 including the application of control and data signals to memory array 101 through DBI generator 114, write circuit 124, and sense circuit 126.

DBI generator 114 receives data words to write to memory array 101 from controller 120. In one embodiment, DBI generator 114 determines whether the number of data bits to be reset to the amorphous state within the data word exceeds half the data word length. In this embodiment, compare circuit 116 is not used and is excluded. If the number of data bits to be reset to the amorphous state exceeds half the word length, DBI generator 114 inverts the data word and sets a DBI flag linked to the data word to a logic high state. If the number of data bits to be reset to the amorphous state does not exceed half the word length, DBI generator 114 does not invert the data word and sets the DBI flag linked to the data word to a logic low state. In another embodiment, DBI generator 114 sets the DBI flag linked to the data word to a logic high state to indicate the data word is not inverted and to a logic low state to indicate the data word is inverted.

In another embodiment, where optional compare circuit 116 is used, DBI generator 114 receives data words to write to memory array 101 from controller 120. Compare circuit 116 also receives the data words to be written to memory array 101. In addition, compare circuit 116 receives data words read from memory array 101 from sense circuit 126. The read data words from sense circuit 126 are the data words in memory array 101 that are going to be overwritten.

Compare circuit 116 compares a data word to write to memory array 101 to the data word read from memory array 101. If the number of matching data bits between the data word to be written and the read data word exceeds half the word length, DBI generator 114 does not invert the data word to be written and sets the DBI flag linked to the data word to a logic low state. If the number of matching data bits between the data word to be written and the read data word does not exceed half the word length, DBI generator 114 inverts the data word to be written and sets the DBI flag linked to the data word to a logic high state. In another embodiment, DBI generator 114 sets the DBI flag linked to the data word to a logic high state to indicate the data word is not inverted and to a logic low state to indicate the data word is inverted.

Write circuit 124 receives the non-inverted or inverted data words and the associated DBI flags from DBI generator 114. Write circuit 124 writes the data words and the DBI flags to memory cells 104 within memory array 101. In one embodiment, write circuit 124 provides voltage pulses through signal path 125 and bit lines 112 to memory cells 104 to program the memory cells. In other embodiments, write circuit 124 provides current pulses through signal path 125 and bit lines 112 to memory cells 104 to program the memory cells.

During a set operation of a phase change memory cell 104, a word line 110 is selected to activate a transistor 108. With transistor 108 activated, one or more set current or voltage pulses are selectively enabled by write circuit 124 and sent through bit line 112 to phase change element 106 thereby heating phase change element 106 above its crystallization temperature (but usually below its melting temperature). In this way, the phase change element 106 reaches its crystalline state during this set operation.

During a reset operation of a phase change memory cell 104, a word line 110 is selected to activate a transistor 108. With transistor 108 activated, a reset current or voltage pulse is selectively enabled by write circuit 124 and sent through bit line 112 to phase change element 106. The reset current or voltage quickly heats phase change element 106 above its melting temperature. After the current or voltage pulse is turned off, phase change element 106 quickly quench cools into the amorphous state.

Sense circuit 126 reads each of the two states of memory cells 104 through bit lines 112 and signal path 127 to read data words and associated DBI flags from memory array 101. In one embodiment, to read the resistance of one of the memory cells 104, sense circuit 126 provides current that flows through one of the memory cells 104. Sense circuit 126 then reads the voltage across that one of the memory cells 104. In another embodiment, sense circuit 126 provides voltage across one of the memory cells 104 and reads the current that flows through that one of the memory cells 104. In another embodiment, write circuit 124 provides voltage across one of the memory cells 104, and sense circuit 126 reads the current that flows through that one of the memory cells 104. In another embodiment, write circuit 124 provides current that flows through one of the memory cells 104, and sense circuit 126 reads the voltage across that one of the memory cells 104. In one embodiment, sense circuit 126 provides read data words to compare circuit 116 and the DBI flag is ignored in response to the read portion of a read-modify-write operation. In another embodiment in response to a read operation, sense circuit 126 reads the DBI flag and inverts the read data word if the DBI flag indicates the data word is inverted. The original non-inverted data word is then provided to controller 120.

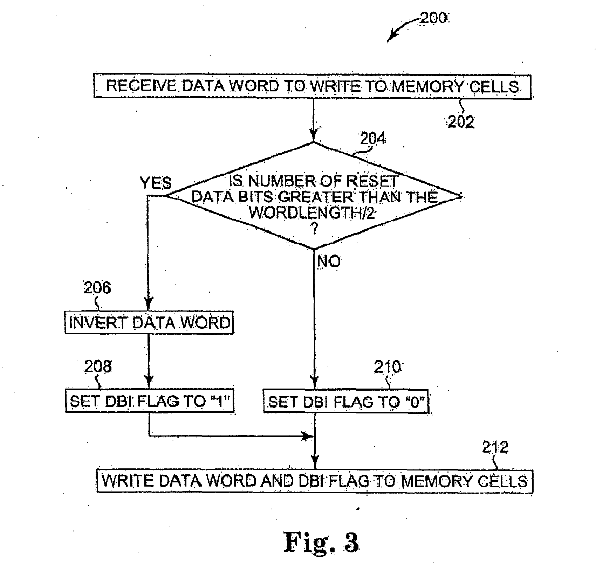

Figure 3 is a flow diagram illustrating one embodiment of a method 200 for writing to a memory array, such as memory array 101. At 202, a data word to be written to memory cells 104 is received by DBI generator 114 from controller 120. At 204, DBI generator 114 determines whether the number of reset data bits (i.e., bits to be reset to the amorphous state) within the data word is greater than the word length divided by two. If the number of reset data bits exceeds the word length divided by two, DBI generator 114 inverts the data word at 206. At 208, DBI generator 114 sets the DBI flag for the data word to a logic high or "1" state indicating that the data word is inverted.

If the number of reset data bits does not exceed the word length divided by two, DBI generator 114 does not invert the data word. At 210, DBI generator 114 sets the DBI flag for the data word to a logic low or "0" state indicating that the data word is not inverted. After DBI generator 114 sets the DBI flag, at 212 the data word (non-inverted or inverted) and the DBI flag for the data word are written to memory cells 104 within memory array 101 by write circuit 124. In this way, the total number of memory cells 104 reset to the amorphous state is minimized, thereby conserving power and/or increasing stability.

For example, if DBI generator 114 receives the data word "01001100", DBI generator 114 determines that the data word includes three data bits to be reset to the amorphous state. Since three is less than four (i.e., the word length eight divided by two), DBI generator 114 does not invert the data word. DBI generator 114 sets the DBI flag linked to the data word to "0" to indicate that the data word is not inverted.

If DBI generator 114 receives the data word "10110011", DBI generator 114 determines that the data word includes five data bits to be reset to the amorphous state. Since five is greater than four (i.e., the word length eight divided by two), DBI generator 114 inverts the data word to provide the inverted data word "01001100". The inverted data word includes three data bits to be reset, which is less than the original five data bits to be reset. DBI generator 114 sets the DBI flag linked to the data word to "1" to indicate that the data word is inverted. In this embodiment, the DBI flag bit adds one additional bit to be reset for a total of four bits to be reset.

In another embodiment, method 200 is used to minimize the number of set data bits. In this embodiment, at 204 DBI generator 114 determines whether the number of set data bits within the data word is greater than the word length divided by two. Minimizing the number of set data bits may conserve power during write operations and/or increase stability for resistive memories other than phase change memories.

In another embodiment, the data word currently stored in memory array 101 that is going to be overwritten is read by sense circuit 126. Sense circuit 126 provides the read data word to compare circuit 116. Compare circuit 116 then compares the read data word to the data word to be written. In this embodiment, at 212, the non-inverted or inverted data word is masked during the write operation such that data bits that match the corresponding data bits within the read data word are not overwritten.

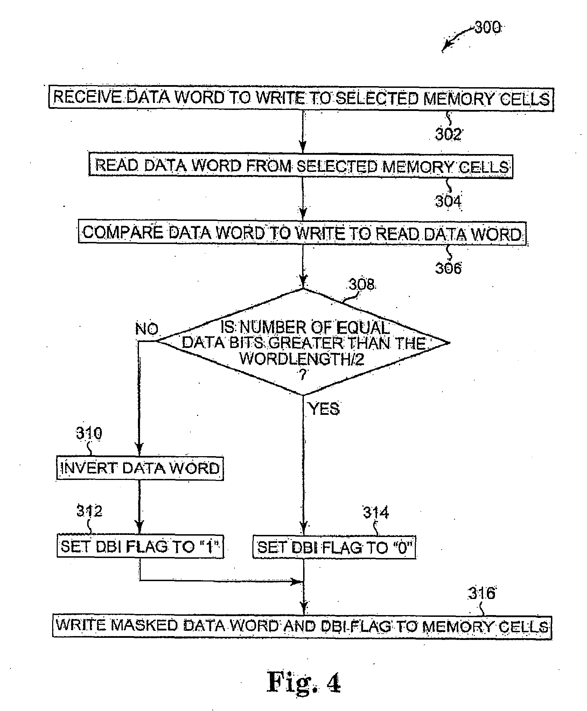

Figure 4 is a flow diagram illustrating another embodiment of a method 300 for writing to a memory array, such as memory array 101. At 302, a data word to be written to selected memory cells 104 is received by DBI generator 114 and compare circuit 116 from controller 120. At 304, the data word currently stored in memory array 101 that is going to be overwritten is read by sense circuit 126. Sense circuit 126 provides the read data word to compare circuit 116. At 306, compare circuit 116 compares the read data word to the data word to be written.

At 308, compare circuit 116 determines whether the number of equal data bits between the read data word and the data word to be written exceeds the word length divided by two. If the number of equal data bits between the read data word and the data word to be written does not exceed the word length divided by two, DBI generator 114 inverts the data word at 310. At 312, DBI generator 114 sets the DBI flag for the data word to a logic high or "1" state indicating that the data word is inverted.

If the number of equal data bits between the read data word and the data word to be written exceeds the word length divided by two, DBI generator 114 does not invert the data word. At 314, DBI generator 114 sets the DBI flag for the data word to a logic low or "0" state indicating that the data word is not inverted. After DBI generator 114 sets the DBI flag, at 316 the data word (non-inverted or inverted) and the DBI flag for the data word are written to memory cells 104 within memory array 101 by write circuit 124. The non-inverted or inverted data word is masked during the write operation such that data bits that match the corresponding data bits within the read data word are not overwritten. In this way, the total number of memory cells that are overwritten is minimized, thereby conserving power and/or increasing stability.

For example in one embodiment, DBI generator 114 and compare circuit 116 receive the data word "01001100" to write to memory array 101 from controller 120. Compare circuit 116 receives the read data word "01111100", which is going to be overwritten, from sense circuit 126. Compare circuit 116 compares the two data words and determines that six data bits are equal. Since six is greater than four (i.e., the word length eight divided by two), DBI generator 114 does not invert the data word to be written. DBI generator 114 sets the DBI flag linked to the data word to "0" to indicate the data word is not inverted. The data bits that are equal to the corresponding data bits within the read data word are then masked such that only the data bits that are not equal are overwritten as indicated by "XX00XXXX", where "X" indicates masked data bits that are not overwritten.

In another embodiment, DBI generator 114 and compare circuit 116 receive the data word "01001140" to write to memory array 101 from controller 120. Compare circuit 116 receives the read data word "00110000", which is going to be overwritten, from sense circuit 126. Compare circuit 116 compares the two data words and determines that three data bits are equal. Since three is not greater than four (i.e., the word length eight divided by two), DBI generator 114 inverts the data word to be written to provide the inverted data word "10110011 ". DBI generator 114 sets the DBI flag linked to the data word to "1" to indicate the data word is inverted. The inverted data bits that are equal to the corresponding data bits within the read data word are then masked such that only the data bits that are not equal are overwritten as indicated by "1XXXXX11", where "X" indicates masked data bits that are not overwritten.

In another embodiment after 306, method 300 skips to 316 where the masked data word is written to memory cells 104 within memory array 101 by write circuit 124. In this embodiment, the data word is not inverted but merely masked to reduce the number of data bits that are overwritten.

Embodiments provide a phase change memory including circuitry for automatically inverting a data word before storing the data word in the memory in response to determining that writing the inverted data word would use less power or provide more stability than writing the original non-inverted data word. A flag indicating the inverted or non-inverted status of the data word is also stored in the memory. The flag is read from the memory with the associated data word such that the original non-inverted data word can be determined and provided to a host upon request.

An integrated circuit is disclosed. The integrated circuit includes an array of resistivity changing memory cells and a circuit configured to invert a data word to be written to the array in response to determining that writing the inverted data word would use less power than writing the non-inverted data word.

In one implementation, the integrated circuit is configured to receive a data word to be written to the array, invert the data word in response to determining that the data word includes more reset data bits than set data bits, set a flag indicating whether the data word has been inverted, and write the data word and the flag to the array.

In another implementation, the circuit is configured to write the flag to a memory cell in an error correction code section of the array, the memory cell not used to store error correction code information.

In a further implementation, the integrated circuit is configured to receive a first data word to be written to the array, read a second data word to be overwritten from the array, invert the first data word in response to determining that the first data word includes a majority of data bits that are different than corresponding data bits of the second data word, set a flag indicating whether the first data word has been inverted, mask the data bits of the first data word that are equal to the corresponding data bits of the second data word, and write the unmasked data bits of the first data word and the flag to the array.

In one implementation, the integrated circuit is configured to write the flag to a memory cell in an error correction code section of the array, the memory cell not used to store error correction code information.

In another implementation, the integrated circuit is configured to receive a data word to be written to the array, invert the data word in response to determining that the data word includes more set data bits than reset data bits, set a flag indicating whether the data word has been inverted, and write the data word and the flag to the array.

Furthermore, a system is disclosed. The system includes a host and a memory device communicatively coupled to the host. The memory device includes an array of resistivity changing memory cells, and a circuit configured to invert a data word to be written to the array in response to determining that writing the inverted data word would use less current than writing the non-inverted data word.

In one implementation, the circuit of the system is configured to receive a data word to be written to the array, invert the data word in response to determining that the data word includes more reset data bits than set data bits, set a flag indicating whether the data word has been inverted, and write the data word and the flag to the array.

In another implementation, the circuit of system is configured to write the flag to a memory cell in an error correction code section of the array, the memory cell not used to store error correction code information.

In a further implementation, the circuit of the system is configured to receive a first data word to be written to the array, read a second data word to be overwritten from the array, invert the first data word in response to determining that the first data word includes a majority of data bits that are different than corresponding data bits of the second data word, set a flag indicating whether the first data word has been inverted, mask the data bits of the first data word that are equal to the corresponding data bits of the second data word, and write the unmasked data bits of the first data word and the flag to the array.

In one implementation, the circuit of the system is configured to write the flag to a memory cell in an error correction code section of the array, the memory cell not used to store error correction code information.

In another implementation, the array of the system includes an array of phase change memory cells.

Furthermore, a memory is disclosed. The memory includes an array of phase change memory cells, and means for inverting a data word to be written to the array in response to determining that writing the inverted data word would use less power or provide more stability than writing the non-inverted data word.

In one implementation, the means of the memory include means for receiving a data word to be written to the array, means for determining whether the data word includes more data bits to be reset to an amorphous state than data bits to be set to a crystalline state, means for inverting the data word in response to determining that the data word includes more data bits to be reset to the amorphous state than data bits to be set to the crystalline state, means for setting a flag indicating whether the data word has been inverted, and means for writing the data word and the flag to the array.

In another implementation, the means of the memory include means for receiving a first data word to be written to the array, means for reading a second data word to be overwritten from the array, means for comparing the first data word to the second data word, means for inverting the first data word in response to determining that the first data word includes a majority of data bits that are different than corresponding data bits of the second data word, means for setting a flag indicating whether the first data word has been inverted, means for masking the data bits of the first data word that are equal to the corresponding data bits of the second data word, and means for writing the unmasked data bits of the first data word and the flag to the array.

Furthermore, a method for operating a memory is disclosed. The method includes receiving a first data word to be written to a resistivity changing memory, inverting the first data word in response to determining that writing the first data word to the memory would use less power if the first data word were inverted, setting a flag indicating whether the first data word has been inverted, and writing the first data word and the flag to the memory.

In one implementation of the method, inverting the first data word in response to determining that writing the first data word to the memory would use less power if the first data word were inverted includes inverting the first data word in response to determining that the first data word includes more reset data bits and than set data bits.

In another implementation of the method, wherein inverting the first data word in response to determining that writing the first data word to the memory would use less power if the first data word were inverted includes reading a second data word that is to be overwritten from the memory, and inverting the first data word to be written in response to determining that the first data word includes a majority of data bits that are different than corresponding data bits of the second data word.

In a further implementation of the method, writing the flag to the memory includes writing the flag to a memory cell in an error correction code section of the memory, the memory cell not used to store error correction code information.

In one implementation of the method, inverting the first data word in response to determining that writing the first data word to the memory would use less power if the first data word were inverted includes inverting the first data word in response to determining that the first data word includes more set data bits and than reset data bits.

In another implementation, method includes receiving a first data word to be written to an array of phase change memory cells, inverting the first data word in response to determining that writing the inverted first data word to the array would use less power than writing the non-inverted first data word to the array, setting a flag indicating whether the first data word has been inverted, and writing the first data word and the flag to the array.

In a further implementation of the method inverting the first data word in response to determining that writing the inverted first data word to the array would use less power than writing the non-inverted first data word to the array includes inverting the first data word in response to determining that the first data word includes more data bits to be reset to an amorphous state than data bits to be set to a crystalline state.

In one implementation of the method inverting the first data word in response to determining that writing the inverted first data word to the array would use less power than writing the non-inverted first data word to the array includes reading a second data word currently stored in the array that is to be overwritten, comparing the first data word to the second data word, and inverting the first data word in response to determining that the first data word includes a majority of data bits that are different than corresponding data bits of the second data word.

In another implementation of the method writing the first data word includes masking the data bits of the first data word that are equal to the corresponding data bits of the second data word, and writing the unmasked data bits of the first data word to the array.

In a further implementation of the method writing the flag to the array includes writing the flag to a memory cell in an error correction code section of the array, the memory cell not used to store error correction code information.

While the specific embodiments described herein substantially focused on using phase change memory elements, the embodiments can be applied to any suitable type of resistive or resistivity changing memory elements.

Although specific embodiments have been illustrated and described herein, it will be appreciated by those of ordinary skill in the art that a variety of alternate and/or equivalent implementations may be substituted for the specific embodiments shown and described without departing from the scope of the present invention. Furthermore, it will be appreciated by those of ordinary skill in the art that any combination of implementations and embodiments may be made without departing from the scope of the present invention.

This application is intended to cover any adaptations or variations of the specific embodiments discussed herein. Therefore, it is intended that this invention be limited only by the claims and the equivalents thereof.

## Claims

1. An integrated circuit comprising:
an array of resistivity changing memory cells; and
a circuit configured to invert a data word to be written to the array in response to determining that writing the inverted data word would use less power than writing the non-inverted data word.

2. The integrated circuit of claim 1, wherein the circuit is configured to:
receive a data word to be written to the array;
invert the data word in response to determining that the data word includes more reset data bits than set data bits;
set a flag indicating whether the data word has been inverted; and
write the data word and the flag to the array.

3. The integrated circuit of one of claims 1-2, wherein the circuit is configured to write the flag to a memory cell in an error correction code section of the array, the memory cell not used to store error correction code information.

4. The integrated circuit of one of claims 1-3, wherein the circuit is configured to:
receive a first data word to be written to the array;
read a second data word to be overwritten from the array;
invert the first data word in response to determining that the first data word includes a majority of data bits that are different than corresponding data bits of the second data word;
set a flag indicating whether the first data word has been inverted;
mask the data bits of the first data word that are equal to the corresponding data bits of the second data word; and
write the unmasked data bits of the first data word and the flag to the array.

5. The integrated circuit of one of claims 1-4, wherein the circuit is configured to write the flag to a memory cell in an error correction code section of the array, the memory cell not used to store error correction code information.

6. The integrated circuit of one of claims 1-5, wherein the circuit is configured to:
receive a data word to be written to the array;
invert the data word in response to determining that the data word includes more set data bits than reset data bits;
set a flag indicating whether the data word has been inverted; and write the data word and the flag to the array.

7. The integrated circuit of one of the claims 1-6, wherein the array comprises an array of phase change memory cells.

8. A method for operating a memory, the method comprising:
receiving a first data word to be written to a resistivity changing memory;
inverting the first data word in response to determining that writing the first data word to the memory would use less power if the first data word were inverted;
setting a flag indicating whether the first data word has been inverted; and
writing the first data word and the flag to the memory.

9. The method of claim 8, wherein inverting the first data word in response to determining that writing the first data word to the memory would use less power if the first data word were inverted comprises inverting the first data word in response to determining that the first data word includes more reset data bits and than set data bits.

10. The method of one of the claims 8-9, wherein inverting the first data word in response to determining that writing the first data word to the memory would use less power if the first data word were inverted comprises:
reading a second data word that is to be overwritten from the memory; and
inverting the first data word to be written in response to determining that the first data word includes a majority of data bits that are different than corresponding data bits of the second data word.

11. The method of one of the claims 8-10, wherein writing the flag to the memory comprises writing the flag to a memory cell in an error correction code section of the memory, the memory cell not used to store error correction code information.

12. The method of one of the claims 8-11, wherein inverting the first data word in response to determining that writing the first data word to the memory would use less power if the first data word were inverted comprises inverting the first data word in response to determining that the first data word includes more set data bits and than reset data bits.

13. A method for operating a memory, the method comprising:
receiving a first data word to be written to an array of phase change memory cells;
inverting the first data word in response to determining that writing the inverted first data word to the array would use less power than writing the non-inverted first data word to the array;
setting a flag indicating whether the first data word has been inverted; and
writing the first data word and the flag to the array.

14. The method of claim 13, wherein inverting the first data word in response to determining that writing the inverted first data word to the array would use less power than writing the non-inverted first data word to the array comprises inverting the first data word in response to determining that the first data word includes more data bits to be reset to an amorphous state than data bits to be set to a crystalline state.

15. The method of one of the claims 13-14, wherein inverting the first data word In response to determining that writing the inverted first data word to the array would use less power than writing the non-inverted first data word to the array comprises:
reading a second data word currently stored in the array that is to be overwritten;
comparing the first data word to the second data word; and
inverting the first data word in response to determining that the first data word includes a majority of data bits that are different than corresponding data bits of the second data word.

16. The method of one of the claims 13-15, wherein writing the first data word comprises:
masking the data bits of the first data word that are equal to the corresponding data bits of the second data word; and
writing the unmasked data bits of the first data word to the array.

17. The method of one of the claims 13-16, wherein writing the flag to the array comprises writing the flag to a memory cell in an error correction code section of the array, the memory cell not used to store error correction code information.
